# FASCICULE DE BREVET EUROPEEN

(11) **EP 2 218 085 B1**
(45) Date de publication et mention de la délivrance du brevet: **29.02.2012**
(21) Numéro de dépôt: 08855979.4
(22) Date de dépôt: 01.12.2008
(51) Int. Cl.: H01H 33/26, G01R 31/12

(54) **DISPOSITIF DE DETECTION ET DE LOCALISATION DE DECHARGES ELECTRIQUES DANS UN EQUIPEMENT ELECTRIQUE A ISOLATION PAR FLUIDE**
VORRICHTUNG ZUR ERKENNUNG UND ORTUNG ELEKTRISCHER LADUNGEN BEI EINEM FLÜSSIGKEITSISOLIERTEN ELEKTRISCHEN GERÄT
DEVICE FOR DETECTING AND LOCATING ELECTRICAL DISCHARGES IN A FLUID-INSULATED ELECTRICAL APPARATUS

(30) Priorité: 03.12.2007 FR 0759511
(43) Date de publication de la demande: 18.08.2010
(73) Titulaire: AREVA T&D SAS, 92084 Paris La Défense Cedex (FR)
(72) Inventeur: GRIESHABER, Wolfgang, F-69006 Lyon (FR); FANGET, Alain, 01390 Tramoyes (FR)
(74) Mandataire: Ilgart, Jean-Christophe
(86) Numéro de dépôt international: PCT/EP2008/066552
(87) Numéro de publication internationale: WO 2009/071516

(56) Documents cités:
- US-A- 4 446 420
- US-B1- 6 295 190

## Description

### DOMAINE TECHNIQUE

La présente invention concerne un dispositif de détection et de localisation d'au moins une décharge électrique dans un équipement électrique à isolation par fluide.

L'équipement électrique à isolation par fluide concerné peut être par exemple un poste électrique à haute tension sous enveloppe métallique connu sous le terme poste sous enveloppe métallique en français ou un GIS (pour Gas Insulated Switchgear soit appareillage à isolation gazeuse) en anglais. On pourrait envisager que l'équipement électrique à isolation par fluide soit un transformateur placé dans une cuve emplie d'un liquide diélectrique ou un tronçon de jeux de barres à isolation gazeuse.

Les postes sous enveloppes métalliques ou les appareillages à isolation gazeuse comportent dans une enveloppe étanche électriquement conductrice au moins un élément conducteur porté à une haute tension. L'enveloppe est emplie d'un gaz d'isolation tel que l'hexafluorure de soufre. L'enveloppe est portée au potentiel de la terre pour assurer la sécurité du personnel évoluant à proximité de ces équipements électriques. Pour cela, au moins une ligne de mise à la terre relie l'enveloppe à la terre. Généralement, l'enveloppe est formée d'une succession de compartiments attachés bout à bout au moyen de brides et plusieurs lignes de mise à la terre sont utilisées, chacune se trouvant au niveau des brides entre deux compartiments voisins. L'élément conducteur peut être par exemple une barre ou les contacts de l'appareillage comme des sectionneurs ou disjoncteurs. Ces éléments conducteurs sont maintenus sensiblement dans la partie centrale de l'enveloppe à l'aide d'un cône de centrage en matériau diélectrique.

Des cônes en matériau diélectrique peuvent être insérés entre deux tronçons successifs de l'enveloppe.

Cette décharge électrique peut être une décharge partielle, une décharge par effet corona, une décharge disruptive non maintenue ou autre.

La décharge électrique par effet corona est une décharge électrique entraînée par l'ionisation du milieu entourant un conducteur.

Une décharge partielle (connue sous l'acronyme anglais PD pour partial discharge) peut être une fuite diélectrique localisée au sein d'une pièce électriquement isolante sous l'effet d'un fort champ électrique. Une décharge partielle peut apparaître en général dans la pièce isolante ou à proximité de celle-ci à cause d'imperfections telles que des vides, des inclusions, des inhomogénéités. Au moment de l'application de la haute tension, de petites décharges se produisent au niveau de ces imperfections, mais le reste de la pièce isolante suffit à supporter la tension appliquée. Cependant, si le champ électrique est relativement fort, ces petites décharges peuvent ronger le matériau isolant et dégénérer en un amorçage complet après quelques mois ou quelques années de service. Une décharge partielle est un phénomène intermittent et, le plus souvent, invisible à l'oeil.

### ÉTAT DE LA TECHNIQUE ANTÉRIEURE

Pour protéger ce type d'équipement électrique, on cherche à détecter et à localiser les décharges électriques en vue d'en éliminer la source, car ces décharges risquent de détériorer à plus ou moins long terme l'équipement électrique. Les décharges partielles si elles conduisent à un amorçage total peuvent provoquer un endommagement total de l'équipement électrique.

Ces décharges partielles sont de l'ordre de quelques pico coulombs. Les décharges électriques et plus particulièrement les décharges partielles peuvent être détectées en plaçant des capteurs à l'intérieur de l'enveloppe. Ces capteurs peuvent être des capteurs acoustiques, des capteurs capacitifs, des capteurs de courant, par exemple de type bobine de Rogowski comme dans le brevet américain US 4 446 420. L'ennui des ces méthodes est que les capteurs doivent être prévus au moment de la conception et la construction de l'équipement. Ainsi dans le brevet américain précité, les bobines de Rogowski sont placées dans des cavités spécialement aménagées à la liaison entre deux compartiments successifs assemblés bout à bout de l'enveloppe de l'équipement électrique.

Dans d'autres configurations, il est possible de placer des capteurs de type acoustique à l'extérieur de l'enveloppe, ou capacitifs face à un hublot. L'inconvénient de cette configuration est qu'il faut prévoir les hublots et on en utilise de moins en moins dans les postes électriques à haute tension sous enveloppe métallique.

Dans d'autres configurations lorsque différents compartiments de l'enveloppe métallique sont cloisonnés par des cônes diélectriques et que l'on utilise pour la continuité électrique de deux compartiments consécutifs des broches de fixation (en anglais brackets) conductrices qui sont boulonnées à l'extérieur des brides de fixation qui terminent les deux compartiments, un capteur de décharges partielle peut être placé entre les broches conductrices et les cônes diélectriques. Cette dernière configuration devient de moins en moins applicable puisque les cônes diélectriques n'empêchent plus la connexion électrique directe entre des brides de fixation qui terminent les deux compartiments consécutifs.

Dans le document DE 19 758 087 et DE 44 45 596 il est préconisé d'utiliser des bobines de Rogowski pour mesurer des décharges partielles. Dans le premier document, les bobines de Rogowski sont placées sur les traversées d'entrée du transformateur et sur le conducteur neutre. Le neutre peut être relié à la terre ou être isolé de la terre. Dans le dernier cas il est « distribué » au client comme une phase. C'est l'exploitant haute tension qui choisit.

Dans le document DE 44 45 596, le câble à tester est alimenté en courant continu et un condensateur est connecté en parallèle avec lui. Deux bobines de Rogowski sont placées autour d'un conducteur connecté à une borne du condensateur pour détecter les décharges partielles dans le câble.

Dans les deux cas précités, il faut pouvoir accéder au conducteur sous tension seul, c'est-à-dire sans l'enveloppe conductrice, ce qui est impossible dans une sous-station en pleine exploitation. Dans un poste sous enveloppe métallique, seules les traversées aériennes le permettent. Dans le reste du poste l'enveloppe métallique qui conduit aussi du courant empêche la mesure du courant de la barre qu'elle entoure. De plus les diamètres d'enveloppe sont grands et rendent difficile la construction de bobines de Rogowski d'une telle dimension.

### EXPOSÉ DE L'INVENTION

La présente invention a justement comme but de proposer un dispositif de détection et de localisation d'au moins une décharge électrique dans un équipement électrique à isolation par fluide qui ne présente pas les inconvénients mentionnés ci dessus.

Un but de l'invention est de proposer un dispositif de détection et de localisation d'au moins une décharge électrique dans un équipement électrique à isolation par fluide tout à fait quelconque qui n'a pas été conçu initialement pour ce genre de détection et de localisation.

Un autre but de l'invention est de proposer dispositif de détection et de localisation d'au moins une décharge électrique dans un équipement électrique à isolation par fluide qui apporte une grande sécurité à l'opérateur destiné à utiliser le dispositif.

Encore un autre but de l'invention est de pouvoir détecter et de localiser des décharges électriques en s'affranchissant du bruit qui existe inévitablement.

Pour atteindre ces buts l'invention propose d'utiliser des bobines de Rogowski et de les placer à l'extérieur de l'enveloppe, autour de lignes de mise à la terre qui relient de manière classique l'enveloppe à la terre.

Plus particulièrement la présente invention concerne un dispositif de détection et de localisation d'au moins une décharge électrique dans un équipement électrique à isolation par fluide contenu dans une enveloppe électriquement conductrice, l'équipement électrique étant muni de plusieurs lignes de mise à la terre, branchées entre l'enveloppe et la terre, réparties le long de l'enveloppe. Le dispositif comporte plusieurs détecteurs de courant de type bobine de Rogowski, la bobine de chacun des détecteurs étant placée autour d'une des lignes de mise à la terre, chaque détecteur délivrant un signal représentatif d'un courant circulant dans ladite ligne de mise à la terre, la survenue d'une décharge électrique se traduisant par une variation brusque du courant, et des moyens pour comparer, en synchronisme, les signaux délivrés par les détecteurs de courant afin de localiser la décharge électrique à l'intérieur d'une zone, interne à l'enveloppe, située à proximité de la ligne de mise à la terre qui est entourée par le détecteur de courant ayant délivré le premier la variation brusque traduisant la décharge électrique.

La bobine d'un détecteur peut être une bobine sensiblement en forme d'anneau susceptible d'être ouvert de manière à pouvoir être installée autour d'une ligne de mise à la terre sans à avoir à déconnecter une des extrémités le ladite ligne de mise à la terre.

En variante, la bobine d'un détecteur peut être une bobine sensiblement en forme d'anneau fermé, la ligne de mise à la terre comportant un tronçon principal de ligne de mise à la terre connecté à l'enveloppe et à la terre et un tronçon dérivé de ligne de mise à la terre, rapporté au niveau d'une première extrémité et d'une deuxième extrémité, en parallèle sur le tronçon principal de ligne de mise à la terre, la bobine du détecteur étant enfilée sur le tronçon dérivé de ligne de mise à la terre.

Le tronçon principal de ligne de mise à la terre peut être électriquement continu entre la première extrémité et la seconde extrémité du tronçon dérivé de ligne de mise à la terre.

En variante le tronçon principal de ligne de mise à la terre peut être électriquement discontinu entre la première extrémité et la seconde extrémité du tronçon dérivé de ligne de mise à la terre, ainsi, le détecteur de courant mesure un courant de plus forte intensité que dans le cas précédent, ce qui permet de détecter des décharges de moindre intensité.

Le dispositif de détection et de localisation peut comporter en outre des moyens d'analyse des signaux délivrés par les détecteurs de courant de manière à distinguer le type de décharge électrique parmi notamment une décharge partielle, une décharge par effet corona, une décharge disruptive non maintenue.

Les signaux délivrés par les détecteurs de courant peuvent être intégrés. Pour un capteur de Rogowski, dont le signal de sortie est proportionnel à la dérivée du courant par rapport au temps, l'intégration permet d'obtenir le courant.

La présente invention concerne également un équipement électrique à isolation par fluide qui comporte un dispositif de détection et de localisation d'au moins une décharge électrique ainsi caractérisé.

Cet équipement électrique peut être, par exemple, un poste électrique à haute tension sous enveloppe métallique ou un appareillage à isolation gazeuse.

La présente invention concerne également un procédé de détection et de localisation d'au moins une décharge électrique dans un équipement électrique à isolation par fluide contenu dans une enveloppe électriquement conductrice, l'équipement électrique étant muni de plusieurs lignes de mise à la terre, branchées entre l'enveloppe et la terre, réparties le long de l'enveloppe, dans lequel on fournit plusieurs détecteurs de courant de type bobine de Rogowski, chacun étant placé autour d'une ligne de mise à la terre, on acquiert des signaux délivrés par chacun des détecteurs de courant et on les compare en synchronisme, la survenue d'une décharge électrique se traduisant par une variation brusque du courant, on localise une décharge électrique à l'intérieur d'une zone interne à l'enveloppe, située à proximité de la ligne de mise à la terre qui est entourée par le détecteur de courant ayant délivré le premier la variation brusque traduisant la décharge électrique.

On peut placer autour d'une ligne de mise à la terre, une bobine de Rogowski sensiblement en forme d'anneau susceptible d'être ouverte.

En variante, lorsque la ligne de mise à la terre comporte un tronçon principal de ligne de mise à la terre connecté à l'enveloppe et à la terre et un tronçon dérivé de ligne de mise à la terre, on peut enfiler la bobine de Rogowski sur le tronçon dérivé de ligne de mise à la terre, la bobine étant sensiblement en forme d'anneau fermé, et connecter le tronçon dérivé de ligne de mise à la terre au niveau d'une première extrémité et d'une seconde extrémité en parallèle sur le tronçon principal de ligne de mise à la terre.

On peut ouvrir le tronçon principal de ligne de mise à la terre entre la première extrémité et la seconde extrémité du tronçon dérivé de ligne de mise à la terre.

On peut de plus, analyser les signaux délivrés par un détecteur de courant ayant délivré le premier un signal traduisant une décharge électrique pour déterminer le type de la décharge électrique qui est survenue.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
la figure 1A montre de manière schématique un équipement électrique sous enveloppe conductrice équipé d'un dispositif de détection et de localisation d'au moins une décharge électrique ;
la figure 1B montre une variante d'un équipement électrique sous enveloppe conductrice équipé d'un dispositif de détection et de localisation d'au moins une décharge électrique ;
la figure 1C montre les signaux délivrées par les capteurs de courant représentés sur la figure 1B ;
la figure 2A montre un appareillage utilisé pour tester le dispositif de détection et de localisation d'au moins une décharge électrique de l'invention ;
les figures 2B, 2C, montrent à différentes échelles un signal délivré par le détecteur de courant de la figure 2A avant l'apparition d'une décharge électrique ;
les figures 3A, 3B, 3C montrent l'installation d'un capteur de courant autour d'un tronçon dérivé de ligne de mise à la terre rapporté sur un tronçon principal de ligne de mise à la terre.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

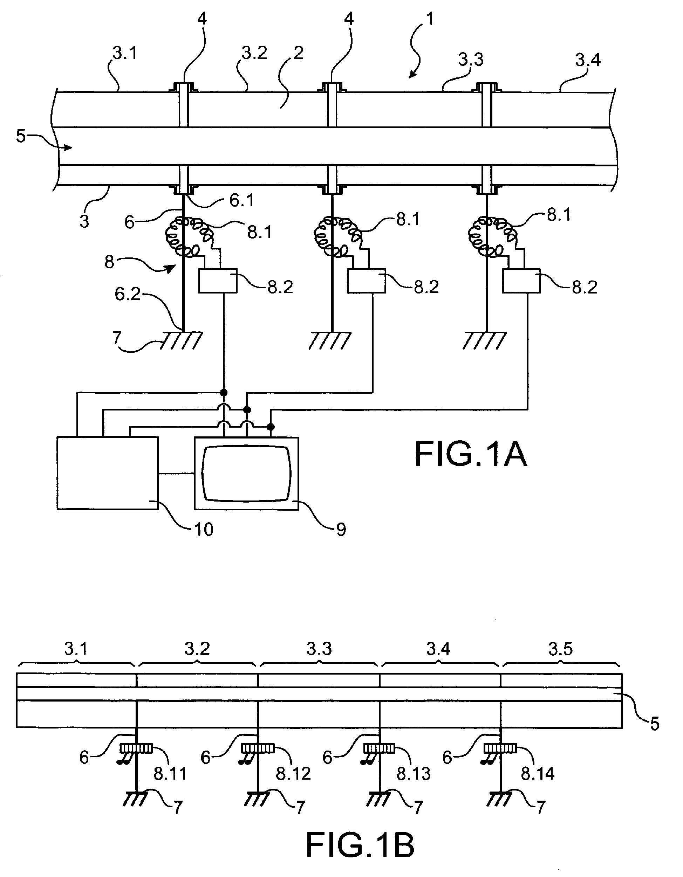

On va se référer à la figure 1A qui montre très schématiquement un équipement électrique 1 à isolation par fluide 2 contenu dans une enveloppe électriquement conductrice 3. Dans l'exemple décrit, l'enveloppe électriquement conductrice 3 prend la forme d'un tube et est formée d'une pluralité de compartiments 3.1, 3.2, 3.3, 3.4 tubulaires assemblés les uns aux autres, par exemple par des brides 4. Les différents compartiments 3.1, 3.2, 3.3, 3.4 ne sont pas forcément assemblés les uns aux autres de manière linéaire. Il n'y a pas d'isolation électrique entre deux compartiments successifs. Le fluide 2 contenu dans l'enveloppe 3 peut être de l'hexafluorure de soufre SF₆. Il baigne un élément conducteur électrique 5, ce dernier pouvant prendre une grande varié de forme : il peut s'agir d'une barre, d'un appareillage de commutation tel un sectionneur ou un disjoncteur, d'un transformateur, ou autre. Cet élément conducteur électrique 5 peut être maintenu en place dans l'enveloppe 3 à l'aide de cônes diélectriques (non représentés).

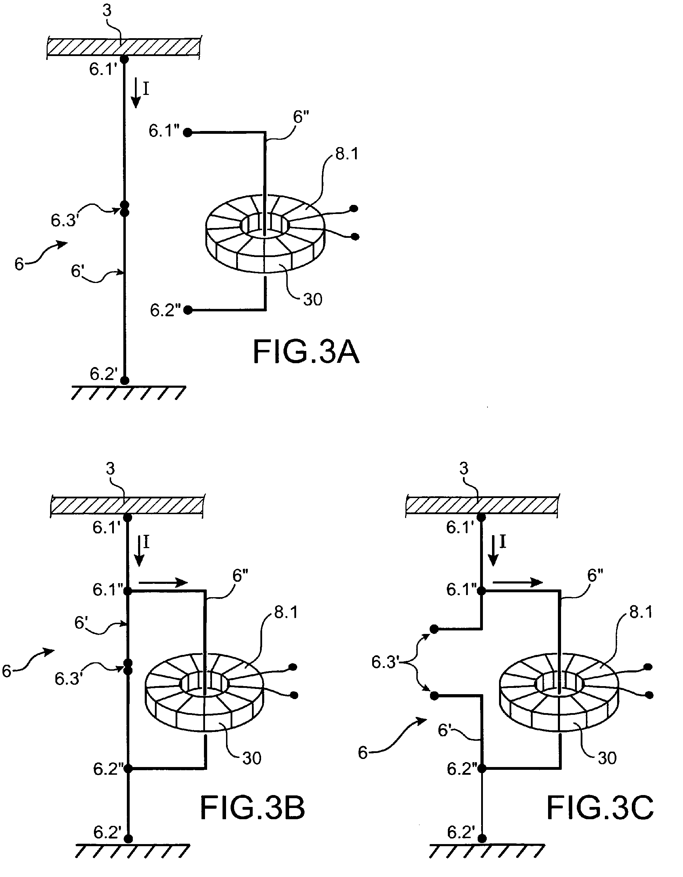

L'équipement électrique 1 est muni de plusieurs lignes de mise à la terre 6 qui relient électriquement l'enveloppe 3 à la terre 7. Ces lignes de mise à la terre 6 s'étendent à l'extérieur de l'enveloppe 3 et sont donc accessibles à des opérateurs de maintenance. Ces lignes de mise à la terre 6 sont réparties sensiblement régulièrement le long de l'enveloppe 3 électriquement conductrice pour assurer la sécurité des opérateurs. Elles peuvent être espacées par exemple d'environ dix mètres, l'enveloppe 3 quant à elle étant généralement beaucoup plus longue. Certaines de ces lignes de mise à la terre 6 peuvent être en un seul morceau entre leur extrémité 6.1 connectée à l'enveloppe 3 et leur extrémité 6.2 à la terre 7, d'autres au contraire peuvent être en plusieurs morceaux, connectés les uns aux autres par des connexions démontables 6.3, par exemple vissées. Cette configuration est visible sur les figures 3A, 3B, 3C. Ces lignes de mise à la terre 6 sont destinées à être parcourues par des courants de fuite ou induits, et ces courants de fuite circulent notamment lors de l'apparition de décharges électriques.

Selon l'invention, l'équipement électrique 1 est équipé d'un dispositif de détection et de localisation d'au moins une décharge électrique 8 placé à l'extérieur de l'enveloppe 3.

Ce dispositif de détection et de localisation d'au moins une décharge électrique comporte plusieurs détecteurs de courant 8.1 de type bobine de Rogowski. Chaque bobine de Rogowski 8.1 est placée autour d'une ligne de mise à la terre 6.

On rappelle qu'une bobine de Rogowski est un bobinage hélicoïdal, réalisé dans l'air ou autour d'un noyau amagnétique, conformé sensiblement en anneau. On dispose ce bobinage autour d'un conducteur de telle manière que les champs magnétiques produits par le courant qui parcourt le conducteur, génèrent aux bornes du bobinage une tension proportionnelle à la dérivée du courant qui circule dans le conducteur.

La bobine de Rogowski 8.1 est reliée à un circuit électronique de mise en forme 8.2 qui délivre un signal sensiblement proportionnel au courant qui circule dans le conducteur. Le circuit électronique peut être de type intégrateur mais ce n'est pas une obligation. Le bobinage étant dans l'air ou autour d'un noyau amagnatique, il est sensible uniquement à des variations de courant qui traversent la bobine et n'est pas perturbé par des saturations magnétiques. Sur la figure 1A, les bobines de Rogowski 8.1 sont bobinées dans l'air.

Un autre avantage d'un capteur de courant de type bobine de Rogowski est que sa sensibilité augmente de manière linéaire avec la fréquence du courant à mesurer. Une telle bobine de Rogowski est adaptée pour mesurer de très faibles courants dans la mesure où ces derniers ont une fréquence élevée et c'est le cas pour le courant des décharges électriques et notamment des décharges partielles.

Le dispositif de détection et de localisation d'au moins une décharge électrique 8 comporte également des moyens de comparaison 9 pour comparer en synchronisme les signaux délivrés par chacun des détecteurs de courant 8.1.

L'analyse en synchronisme des signaux délivrés par les différents détecteurs de courant 8.1 permet de localiser le lieu de naissance des décharges électriques. L'apparition d'une décharge électrique se traduit au niveau du signal délivré par le détecteur de courant par exemple par une variation brusque en forme de salves d'impulsions.

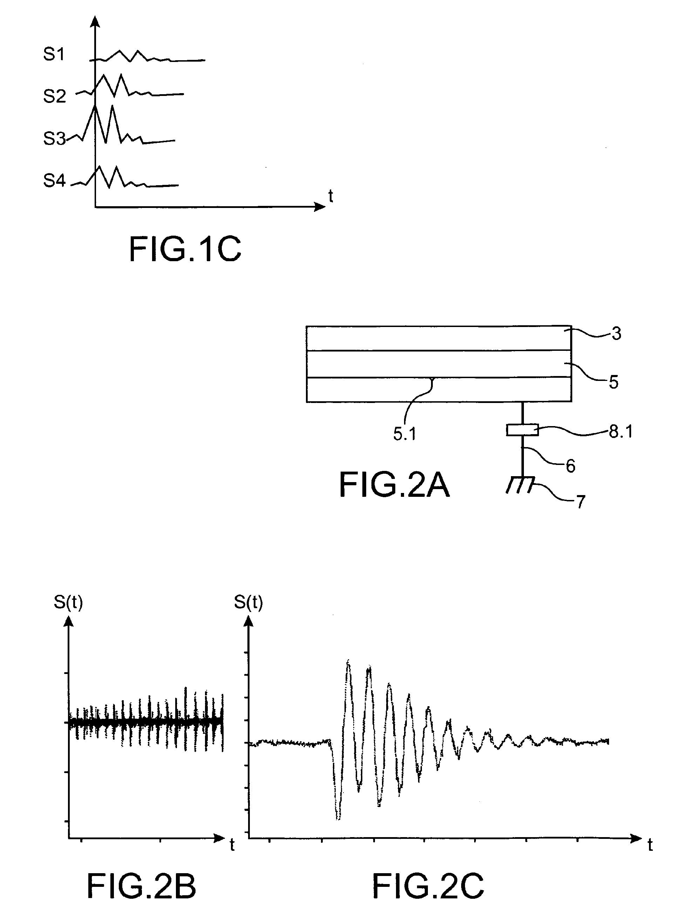

Sur la figure 1B, on a représenté de manière encore plus schématique quatre détecteurs de courant 8.11, 8.12, 8.13, 8.14 placés chacun autour d'une ligne de mise à la terre 6 d'un équipement électrique 1 dont l'enveloppe 3 est morcelée en cinq compartiments 3.1, 3.2, 3.3, 3.4, 3.5. Sur la figure 1C on a représenté les signaux S1, S2, S3, S4 délivrés respectivement par les quatre détecteurs de courant 8.11, 8.12, 8.13, 8.14, tels qu'ils pourraient s'afficher sur un oscilloscope. On s'aperçoit que les variations brusques du courant, signe de l'apparition de la décharge électrique, sont décalées dans le temps selon les capteurs de courant considérés 8.11, 8.12, 8.13, 8.14. De plus ces variations brusques n'ont pas les mêmes amplitudes.

Sur la figure 1C, c'est le capteur 8.13 qui délivre le premier la variation brusque de courant signe de la décharge électrique. Cette variation brusque du courant a l'amplitude la plus élevée. Les capteurs 8.12 et 8.14 détectent plus tardivement la décharge partielle, les variations brusques de courant qu'ils délivrent ont une amplitude moindre. Le signal S2, S4 que délivrent les capteurs de courant 8.12 et 8.14 est plus distordu. On peut en déduire que la décharge électrique détectée est localisée à l'intérieur de l'enveloppe 3, à proximité de la ligne de mise à la terre 6.13, c'est la ligne de mise à la terre qui est entourée du capteur de courant 8.13 qui a détecté le premier la variation de courant traduisant l'apparition de la décharge électrique. En d'autres termes la décharge électrique est localisée dans le compartiment 3.3 ou le compartiment 3.4. Puisque le signal S2 est un peu en retard sur le signal S4, La décharge sera vraisemblablement localisée dans le compartiment 3.4. Elle est très proche du capteur de courant 8.13. Il est préférable toutefois d'ouvrir les deux compartiments 3.3 et 3.4.

Comme avec les procédés de mesure de décharges électriques conventionnels, le type de défaut ayant engendré la décharge électrique peut être déterminé en analysant la forme du signal S3 délivré par le capteur de courant 8.13 ayant détecté le premier la décharge électrique. L'analyse prend en compte la tension instantanée au début et à la fin du phénomène traduisant la décharge électrique, l'influence de la polarité et la bande de fréquence couverte par le tronçon de signal analysé. Ce type d'analyse est classique pour un homme du métier qui met en oeuvre un dispositif de détection et de localisation d'au moins une décharge électrique, c'est pourquoi nous ne donnerons pas plus de détails. Les moyens d'analyse sont référencés 10. On peut ainsi déterminer s'il s'agit d'une décharge partielle, d'une décharge par effet corona, d'une décharge disruptive non maintenue ou autre.

La figure 2A montre une bobine de Rogowski 8.1 disposée autour d'une ligne de mise à la terre 6 d'une enveloppe 3 contenant un élément conducteur 5 qui peut être une barre. Lors d'un test diélectrique prouvant à démontrer l'intérêt du dispositif de détection et de localisation d'au moins une décharge électrique selon l'invention, on enregistre les signaux délivrés par le capteur de courant 8.1 avant l'apparition de la décharge partielle. Les enregistrements des figures 2B, 2C illustrent, à différentes échelles, les signaux S(t) délivrés par le capteur de courant 8.1 dans les instants qui précèdent la rupture diélectrique, cette rupture engendrant une décharge partielle entre la barre 5 et l'enveloppe 3. Une aspérité référencée 5.1 est vraisemblablement l'origine de la décharge partielle.

La société KEMA propose un logiciel de traitement et d'analyse de signaux délivrés par des capteurs dans le stator d'un alternateur, destiné à y localiser au moins une décharge électrique et même à déterminer la nature de la décharge. Ce logiciel est tout à fait adapté à l'application envisagée pour la détection et la localisation de décharges électriques. La demande de brevet WO 2004/051291 décrit un procédé mis en oeuvre par ce logiciel. Le procédé ne sera donc pas décrit plus en détail. Il peut être utilisé pour détecter et localiser automatiquement une décharge électrique dans l'équipement électrique.

On peut utiliser des bobines de Rogowski 8.1 susceptibles d'être ouvertes pour effectuer les mesures. Elles ne sont pas difficiles à installer autour des lignes de descente de terre sans à avoir à déconnecter ces dernières. Il est important pour la qualité du signal que la bobine soit fermée au moment de la mesure. Ces bobines de Rogowski sont généralement bobinées dans l'air. De telles bobines de Rogowski sont représentées sur la figure 1A.

Par contre si on ne dispose que de bobines de Rogowski fermées, par exemple bobinées sur un noyau amagnétique 30, sensiblement en forme d'anneau fermé, la mesure peut se faire également sans à avoir à interrompre la liaison électrique entre l'enveloppe 3 et la terre 7. On se réfère aux figures 3A, 3B, 3C. Il suffit de disposer d'un tronçon dérivé de ligne de mise à la terre 6" en plus d'un tronçon principal de ligne de mise à la terre 6' qui relie classiquement l'enveloppe 3 à la terre 7. Les extrémités du tronçon principal de ligne de mise à la terre 6' sont appelées 6.1', 6.2'. C'est l'ensemble des deux tronçons qui va former la ligne de mise à la terre 6. Dans ce cas la ligne de mise à la terre 6 va comporter le tronçon de ligne de mise à la terre 6' appelé tronçon principal de ligne de mise à la terre 6' et on lui associe le tronçon dérivé de ligne de mise à la terre 6". Le tronçon dérivé de ligne de mise à la terre 6" est rapporté sur le tronçon principal de mise à la terre 6'. La bobine de Rogowski 8.1 est enfilée sur le tronçon dérivé de mise à la terre 6" avant que ce dernier ne soit connecté au niveau de ses extrémités 6.1", 6.2" au tronçon principal de ligne de mise à la terre 6'. Le tronçon principal de ligne de mise à la terre peut comporter une connexion démontable 6.3' située entre ses deux extrémités 6.1' et 6.2'. Les extrémités 6.1", 6.2" du tronçon dérivé 6" sont fixées au tronçon principal de ligne de mise à la terre 6' de part et d'autre de la connexion démontable 6.3'. Du courant se répartira dans le tronçon principal de ligne de mise à la terre 6' et dans le tronçon dérivé de ligne de mise à la terre 6", et c'est la fraction de courant circulant dans le tronçon dérivé de ligne de mise à la terre dérivé 6" qui sera mesurée (figure 3B).

Si l'on préfère que la mesure concerne une intensité de courant plus importante, il est possible d'ouvrir le tronçon principal de ligne de mise à la terre 6' au niveau de la connexion démontable 6.3' de manière à ce que la totalité du courant circule dans le tronçon dérivé de ligne de mise à la terre 6". La bobine de Rogowski mesurera alors la totalité du courant circulant dans la ligne de mise à la terre et pas seulement une fraction.

Un avantage d'utiliser des capteurs de courant placés à l'extérieur de l'enveloppe est que leur utilisation peut se faire sur un équipement électrique quelconque et pendant qu'il est en service, la méthode employée étant non intrusive. Dans les équipements électriques concernés par l'invention, les lignes de mise à la terre sont nombreuses et aisément accessibles, alors que dans l'art antérieur les détecteurs externes devaient être placés à un plus faible nombre d'endroits bien particuliers pas forcément accessibles, endroits au niveau desquels le champ électrique rayonnait hors de l'enveloppe, par exemple face à des hublots ou au niveau de la liaison entre des compartiments successifs.

Le dispositif et le procédé de l'invention garantissent la sécurité de l'opérateur devant faire les mesures, puisque les bobines de Rogowski sont isolées de manière galvanique de l'équipement électrique à tester.

L'utilisation des bobines de Rogowski permet d'atteindre un niveau élevé d'élimination de bruit à cause de la détection intégrale du champ magnétique autour de la ligne de mise à la terre.

## Revendications

1. Dispositif de détection et de localisation d'au moins une décharge électrique dans un équipement électrique (1) à isolation par fluide contenu dans une enveloppe (3) électriquement conductrice, l'équipement électrique étant muni de plusieurs lignes de mise à la terre (6), branchées entre l'enveloppe (3) et la terre (7), réparties le long de l'enveloppe (3), le dispositif comportant plusieurs détecteurs de courant (8.1) de type bobine de Rogowski, et des moyens pour comparer (9), en synchronisme, les signaux délivrés par les détecteurs de courant (8.1) afin de localiser la décharge électrique, **caractérisé en ce que** la bobine (8.1) de chacun des détecteurs est placée autour d'une des lignes de mise à la terre (6), chaque détecteur délivrant un signal représentatif d'un courant circulant dans ladite ligne de mise à la terre, la survenue d'une décharge électrique se traduisant par une variation brusque du courant, la décharge électrique étant localisée à l'intérieur d'une zone interne à l'enveloppe (3) située à proximité de la ligne de mise (6) à la terre qui est entourée par le détecteur de courant (8.1) ayant délivré le premier la variation brusque traduisant la décharge électrique.

2. Dispositif de détection et de localisation selon la revendication 1, dans lequel la bobine (8.1) d'un détecteur est une bobine sensiblement en forme d'anneau susceptible d'être ouvert de manière à pouvoir être placée autour d'une ligne de mise à la terre (6) sans à avoir à déconnecter une des extrémités le ladite ligne de mise à la terre.

3. Dispositif de détection et de localisation selon la revendication 1, dans lequel la bobine (8.1) d'un détecteur est une bobine sensiblement en forme d'anneau fermé, la ligne de mise à la terre comportant un tronçon principal de ligne de mise à la terre (6') connecté à l'enveloppe (3) et à la terre (7) et un tronçon dérivé de ligne de mise à la terre (6"), rapporté au niveau d'une première extrémité (6.1") et d'une deuxième extrémité (6.2"), en parallèle sur le tronçon principal de ligne de mise à la terre (6'), la bobine du détecteur (8.1) étant enfilée sur le tronçon dérivé de ligne de mise à la terre (6").

4. Dispositif de détection et de localisation selon la revendication 3, dans lequel le tronçon principal de ligne de mise à la terre (6') est électriquement continu entre la première extrémité (6.1") et la seconde extrémité (6.2") du tronçon dérivé de ligne de mise à la terre (6").

5. Dispositif de détection et de localisation selon la revendication 3, dans lequel le tronçon principal de ligne de mise à la terre (6') est électriquement discontinu entre la première extrémité (6.1") et la seconde extrémité (6.2") du tronçon dérivé de ligne de mise à la terre (6").

6. Dispositif de détection et de localisation selon l'une des revendications précédentes, comportant en outre des moyens de traitement (10) des signaux délivrés par les détecteurs de courant de manière à distinguer le type de décharge électrique parmi notamment une décharge partielle, une décharge par effet corona, une décharge disruptive non maintenue.

7. Dispositif de détection et de localisation selon l'une des revendications précédentes, dans lequel les signaux délivrés par les détecteurs de courant (8.1) sont intégrés.

8. Equipement électrique à isolation par fluide, **caractérisé en ce qu'**il comporte un dispositif de détection et de localisation d'au moins une décharge électrique selon l'une des revendications précédentes.

9. Equipement électrique selon la revendication 8, **caractérisé en ce que** c'est un poste électrique à haute tension sous enveloppe métallique ou un appareillage à isolation gazeuse.

10. Procédé de détection et de localisation d'au moins une décharge électrique dans un équipement électrique (1) à isolation par fluide contenu dans une enveloppe (3) électriquement conductrice, l'équipement électrique étant muni de plusieurs lignes de mise à la terre (6), branchées entre l'enveloppe (3) et la terre (7), réparties le long de l'enveloppe (3), dans lequel on fournit plusieurs détecteurs de courant (8.1) de type bobine de Rogowski, chacun étant placé autour d'une ligne de mise à la terre (6), on acquiert des signaux délivrés par chacun des détecteurs de courant (8.1) et on les compare en synchronisme, la survenue d'une décharge électrique se traduisant par une variation brusque du courant, on localise une décharge électrique à l'intérieur d'une zone interne à l'enveloppe (3) située à proximité de la ligne de mise à la terre (6) qui est entourée par le détecteur de courant (8.1) ayant délivré le premier la variation brusque traduisant la décharge électrique.

11. Procédé de détection et de localisation d'au moins une décharge électrique selon la revendication 10, dans lequel on place autour d'une ligne de mise à la terre (6) une bobine de Rogowski sensiblement en forme d'anneau susceptible d'être ouvert.

12. Procédé de détection et de localisation d'au moins une décharge électrique selon la revendication 10, dans lequel la ligne de mise à la terre (6) comporte un tronçon principal de ligne de mise à la terre (6') connecté à l'enveloppe (3) et à la terre et un tronçon dérivé de ligne de mise à la terre (6"), dans lequel on enfile la bobine de Rogowski (8.1) sur le tronçon dérivé de ligne de mise à la terre (6"), la bobine étant sensiblement en forme d'anneau fermé, on connecte le tronçon dérivé de ligne de mise à la terre (6") au niveau d'une première extrémité (6.1") et d'une seconde extrémité (6.2") en parallèle sur le tronçon principal de ligne de mise à la terre (6').

13. Procédé de détection et de localisation d'au moins une décharge électrique selon la revendication 12, dans lequel on ouvre le tronçon principal de ligne de mise à la terre (6') entre la première extrémité (6.1") et la seconde extrémité (6.2") du tronçon dérivé de ligne de mise à la terre (6").

14. Procédé de détection et de localisation d'au moins une décharge électrique selon l'une des revendications 10 à 13, dans lequel on analyse les signaux délivrés par un détecteur de courant (8.1) ayant délivré le premier un signal traduisant une décharge électrique pour déterminer le type de la décharge électrique qui est survenue.

## Claims

1. A device for detecting and locating at least one electric discharge in electrical equipment (1) insulated by fluid contained in electrically-conductive housing (3), the electrical equipment being provided with a plurality of grounding lines (6) connected between the housing (3) and ground (7) and distributed along the housing (3), the device comprising a plurality of current detectors (8.1) of the Rogowski coil type, and means (9) for synchronously comparing the signals delivered by the current detectors (8.1) in order to locate the electric discharge, **characterized in that** the coil (8.1) of each of the detectors is placed around a respective grounding line (6), each detector delivering a signal representative of current flowing in said grounding line, the occurrence of an electric discharge giving rise to a sudden variation of the current, the electric discharge being located within a zone inside the housing (3) and situated in the proximity of the grounding line (6) that is surrounded by the current detector (8.1) that was the first to deliver the sudden variation representative of the electric discharge.

2. A detection and locating device according to claim 1, in which the coil (8.1) of a detector is a coil substantially in the form of a ring that can be opened so as to enable it to be placed around a grounding line (6) without it being necessary to disconnect one of the ends of said grounding line.

3. A detection and locating device according to claim 1, in which the coil (8.1) of a detector is a coil substantially in the form of a closed ring, the grounding line comprising a main grounding line segment (6') connected to the housing (3) and to ground (7), and a secondary grounding line segment (6") connected at first end (6.1") and second end (6.2") in parallel with the main grounding segment (6'), the detector coil (8.1) being threaded around the secondary grounding line segment (6").

4. A detection and locating device according to claim 3, in which the main grounding line segment (6') is electrically continuous between the first end (6.1") and the second end (6.2") of the secondary grounding line segment (6").

5. A detection and locating device according to claim 3, in which the main grounding line segment (6') is electrically discontinuous between the first end (6.1") and the second end (6.2") of the secondary grounding line segment (6").

6. A detection and locating device according to any preceding claim, further including processor means (10) for processing signals delivered by the current detectors in order to distinguish the type of electric discharge from amongst a partial discharge, a corona effect discharge, and a non-maintained disruptive discharge.

7. A detection and locating device according to any preceding claim, in which the signals delivered by the current detectors (8.1) are integrated.

8. Fluid-insulated electrical equipment, **characterized in that** it includes a device according to any preceding claim for detecting and locating at least one electric discharge.

9. Electrical equipment according to claim 8, **characterized in that** it is a metal-housing high voltage electricity unit or gas-insulated switch gear or control gear.

10. A method of detecting and locating at least one electric discharge in electrical equipment (1) insulated by fluid contained in electrically-conductive housing (3), the electrical equipment being provided with a plurality of grounding lines (6) connected between the housing (3) and ground (7), and distributed along the housing (3), in which a plurality of current detectors (8.1) of the Rogowski coil type are provided, each being placed around a respective grounding line (6), the signals delivered by each of the current detectors (8.1) are acquired and compared synchronously, with the occurrence of an electric discharge giving rise to a sudden variation in the current, and an electric discharge is located as being within a zone inside the housing (3) situated in the proximity of the grounding line (6) that is surrounded by the current detector (8.1) that was the first to deliver the sudden variation representative of the electric discharge.

11. A method according to claim 10 for detecting and locating at least one electric discharge, in which a Rogowski, coil that is substantially in the form of a ring suitable for being opened is placed around a grounding line (6).

12. A method according to claim 10 for detecting and locating at least one electric discharge, in which the grounding line (6) comprises both a main grounding line segment (6') connected to the housing (3) and to ground, and a secondary grounding line segment (6"), and in which the Rogowski coil (8.1) is engaged around the secondary grounding line segment (6"), the coil being substantially in the form of a closed ring, and the secondary grounding line segment (6") being connected at first end (6.1") and second end (6.2") in parallel with the main grounding line segment (6').

13. A method according to claim 12 for detecting and locating at least one electric discharge, in which the main grounding line segment (6') between the first end (6,1") and the second end (6.2") of the secondary grounding line segment (6") is opened.

14. A method according to any one of claims 10 to 13 for detecting and locating at least one electric discharge, in which the signals delivered by a current detector (8.1) that was the first to deliver a signal representative of an electric discharge is analyzed in order to determine the type of the electric discharge that has occurred.

## Patentansprüche

1. Vorrichtung zur Erkennung und Ortung zumindest einer elektrischen Entladung bei einer fluidisolierten, elektrischen Einrichtung (1), die in einer elektrisch leitfähigen Kapselung (3) enthalten ist, wobei die elektrische Einrichtung mit mehreren Erdungsleitungen (6) versehen ist, die zwischen Kapselung (3) und Erde (7) angeschlossen und entlang der Kapselung (3) verteilt angeordnet sind, wobei die Vorrichtung mehrere Stromfühler (8.1) vom Typ Rogowski-Spule und Mittel (9) zum gleichzeitigen Vergleichen der von den Stromfühlern (8.1) ausgegebenen Signale aufweist, um die elektrische Entladung zu orten, **dadurch gekennzeichnet, dass** die Spule (8.1) eines jeden der Stromfühler um eine der Erdurtgsleitungen (6) herum gelegt ist, wobei jeder Stromfühler ein Signal ausgibt, das repräsentativ ist für einen in der Erdungsleitung fließenden Strom, wobei das Auftreten einer elektrischen Entladung sich in einer plötzlichen Stromschwankung äußert, wobei die elektrische Entladung im Innenraum eines Bereichs innerhalb der Kapselung (3) geortet wird, der sich in der Nähe der Erdungsleitung (6) befindet, die von dem Stromfühler (8.1) umgeben ist, der als erster die plötzliche Schwankung abgegeben hat, in welcher sich die elektrische Entladung äußert.

2. Vorrichtung zur Erkennung und Ortung nach Anspruch 1, wobei die Spule {8.1} eines Stromfühlers eine Spule im wesentlichen in Form eines Rings ist, der so geöffnet werden kann, dass er um eine Erdungsleitung (6) herum gelegt werden kanrt, ohne dabei eines der Enden der Erdungsleitung abtrennen zu müssen.

3. Vorrichtung zur Erkennung und Ortung nach Anspruch 1, wobei die Spule (8.1) eines Stromfühlers eine Spule im wesentlichen in Form eines geschlossenen Rings ist, wobei die Erdungsleitung einen Erdungsleitungshaupfiabschnitt (6') aufweist, der mit der Kapselung (3) und mit der Erde (7) verbunden ist, sowie einen Erdungsleitungsabzweigabschnitt (6"), der im Bereich eines ersten Endes (6.'1 ") und eines zweiten Endes (6.2") parallel zum Erdungsleitungshauptabschnitt (6') angeordnet ist, wobei die Spule des Stromfühlers (8.1) dem Erdungsleitungsabzweigabschnitt (6") übergestülpt ist.

4. Vorrichtung zur Erkennung und Ortung nach Anspruch 3, wobei der Erdungsleitungshauptabschnitt (6') zwischen dem ersten Ende (6.1") und dem zweiten Ende (6.2") des Erdungsleitungsabzweigabschnitts (6") elektrisch durchgehen ist.

5. Vorrichtung zur Erkennung und Ortung nach Anspruch 3, wobei der Erdungsleitungshauptabschnitt (6') zwischen dem ersten Ende (6.1") und dem zweiten Ende (6.2") des Erdungsleitungsabzweigabschnitts (6") elektrisch unterbrechen ist.

6. vorrichtung zur Erkennung und Ortung nach einem der vorangehenden Ansprüche, ferner enthaltend Verarbeitungsmittel (10) zum Verarbeiten der von den Stromfühlern ausgegebenen Signale, so dass die Art von elektrischer Entladung insbesondere nach einer Teilentladung, einer Korona-Entladung und einer nicht aufrechterhaltenen Durchschlagsentladung unterschieden wird.

7. Vorrichtung zur Erkennung und Ortung nach einem der vorangehenden Ansprüche, wobei die von den Stromfühlern (8.1) ausgebebenen Signale integriert werden.

8. Fluidisolierte, elektrische Einrichtung, **dadurch gekennzeichnet, dass** sie eine Vorrichtung zur Erkennung und Ortung von zumindest einer elektrischen Entladung nach einem der vorangehenden Ansprüche aufweist.

9. Elektrische Einrichtung nach Anspruch 8, **dadurch gekennzeichnet, dass** es sich um eine metallgekapselte Hochspannungsschaltanlage bzw. um eine gasisolierte Schalteinrichtung handelt.

10. Verfahren zur Erkennung und Ortung zumindest einer elektrischen Entladung bei einer fluidisolierten, elektrischen Einrichtung (1), die in einer elektrisch leitfähigen Kapselung (3) enthalten ist, wobei die elektrische Einrichtung mit mehreren Erdungsleitungen (6) versehen ist, die zwischen Kapselung (3) und Erde (7) angeschlossen und entlang der Kapselung (3) verteilt angeordnet sind, wobei mehrere Stromfühler (8.1) vom Typ Rogowski-Spule bereitgestellt werden, von denen jeder um eine Erdungsleitung (6) herum gelegt ist, wobei Signale erfasst werden, die von jedem der Stromfühler (8.1) ausgegeben und gleichzeitig verglichen werden, wobei das Auftreten einer elektrischen Entladung sich in einer plötzlichen Stromschwankung äußert, wobei eine elektrische Entladung im Innenraum eines Bereichs innerhalb der Kapselung (3) geortet wird, der sich in der Nähe der Erdungsleitung (6) befindet, die von dem Stromfühler (8.1) umgeben ist, der als erster die plötzliche Schwankung abgegeben hat, in welcher sich die elektrische Entladung äußerst.

11. Verfahren zur Erkennung und Ortung zumindest einer elektrischen Entladung nach Anspruch 10, wobei um eine Erdungsleitung (6) herum eine Rogowski-Spule gelegt wird, die im wesentlichen in Form eines Rings vorliegt, der geöffnet werden kann.

12. Verfahren zur Erkennung und Ortung zumindest einer elektrischen Entladung nach Anspruch 10, wobei die Erdungsleitung (6) einen Erdungsleitungshauptabschnitt (6') aufweist, der mit der Kapselung (3) und mit der Erde verbunden ist, sowie einen Erdungsleitungsabzweigabschnitt (6"), wobei die Rogowski-Spule (8.1) dem Erdungsleitungsabzweigabschnitt (6") übergestülpt wird, wobei die Spule im wesentlichen in Form eines geschlossenen Rings vorliegt, wobei der Erdungsleitungsabzweigabschnitt (6") im Bereich eines ersten Endes (6.1") und eines zweiten Endes (6.2") parallel zum Erdungsleitungshauptabschnitt (6') angeschlossen wird.

13. Verfahren zur Erkennung und Ortung zumindest einer elektrischen Entladung nach Anspruch 12, wobei der Erdungsleitungshauptabschnitt (6') zwischen dem ersten Ende (6.1") und dem zweiten Ende (6.2") des Erdungsleitungsabzweigabschnitts (6") geöffnet wird.

14. Verfahren zur Erkennung und Ortung zumindest einer elektrischen Entladung nach einem der Ansprüche 10 bis 13, wobei zum Ermittein der Art von aufgetretener elektrischer Entladung die Signale analysiert werden, die von einem Stromfühlers (8.1) ausgegeben wurden, der als erster ein Signal ausgegeben hat, in welchem sich eine elektrische Entladung äußerst.
